# EUROPÄISCHE PATENTANMELDUNG

(11) **EP 4 481 978 A1**
(43) Veröffentlichungstag der Anmeldung: **25.12.2024**
(21) Anmeldenummer: 23180969.0
(22) Anmeldetag: 22.06.2023
(51) Int. Cl.: H02J 3/38, H02J 9/06, H02H 3/06, G01R 35/00

(54) **VORRICHTUNG UND VERFAHREN ZUR SPANNUNGSABGLEICHENDEN TRENNSCHALTERSTEUERUNG MITTELS KALIBRIERUNG**

(71) Anmelder: Kries-Energietechnik GmbH & Co. KG, 71334 Waiblingen (DE)
(72) Erfinder: Greiner, Ulrich, 70374 Stuttgart (DE); Kries, Gunter, 71384 Weinstadt (DE)
(74) Vertreter: Grünecker Patent- und Rechtsanwälte PartG mbB

(57) **Zusammenfassung**

Vorrichtung und Verfahren zur spannungsabgleichenden Trennschaltersteuerung in einem Stromnetz (1), wobei das Stromnetz einen Trennschalter (2) mit einer ersten Anschlussseite (2a), die von einer ersten Spannung (U₁) beaufschlagbar ist, und einer zweiten Anschlussseite (2b) aufweist, die von einer zweiten Spannung (U₂) beaufschlagbar ist. Die Vorrichtung umfasst eine erste Spannungsmesseinheit (3), die zur zeitwiederholten Gewinnung einer ersten Messspannung (U_{1M}) durch eine Messung der ersten Spannung mit einer vorgegebenen ersten Messgenauigkeit (Mg1) eingerichtet ist, eine zweite Spannungsmesseinheit (4), die zur zeitwiederholten Gewinnung einer zweiten Messspannung (U_{2M}) durch eine Messung der zweiten Spannung mit einer vorgegebenen zweiten Messgenauigkeit (Mg2) eingerichtet ist, die geringer als die erste Messgenauigkeit ist, eine Kalibriereinheit (5), die zur Gewinnung einer kalibrierten zweiten Messspannung (U2k) durch eine Kalibrierung der zweiten Messspannung mit der ersten Messspannung eingerichtet ist, und eine Schaltersteuerungseinheit (6), die zur Steuerung des Trennschalters eingerichtet ist und ein Schließen des Trennschalters von der Erfüllung einer oder mehrerer vorgegebener Zuschaltbedingungen (Zb) abhängig macht, zu denen gehört, dass ein Amplitudendifferenzbetrag der zuletzt gewonnenen kalibrierten zweiten Messspannung und der zuletzt gewonnenen ersten Messspannung einen vorgegebenen Maximalamplitudendifferenzbetrag nicht überschreitet.

## Beschreibung

Die Erfindung bezieht sich auf eine Vorrichtung und ein Verfahren zur spannungsabgleichenden Trennschaltersteuerung in einem Stromnetz, wobei das Stromnetz einen Trennschalter mit einer ersten Anschlussseite, die von einer ersten Spannung beaufschlagbar ist, und einer zweiten Anschlussseite aufweist, die von einer zweiten Spannung beaufschlagbar ist. Die Vorrichtung und das Verfahren eignen sich insbesondere, aber nicht ausschließlich, zur Verwendung in Verteilnetzstationen von Mittelspannungs-Verteilnetzen und auch von Niederspannungs- und Hochspannungs-Verteilnetzen von elektrischen Stromversorgungsnetzen.

Derartige Stromversorgungsnetze und insbesondere solche mit Mittelspannungs-Verteilnetzen verfügen üblicherweise über Umspannwerke und nachgeordnete Verteilnetzstationen, welche die vom Umspannwerk gelieferte Mittelspannung verteilen und dabei sogenannten Ortsnetztransformatoren zuführen, die sich jeweils in einem entsprechenden, als Kundenabgangsfeld fungierenden Ortsnetztransformator-Schaltfeld der Verteilnetzstation befinden.

Unter der Bezeichnung Trennschalter ist vorliegend in einem breiten Sinn jeglicher elektrische Schalter in einem elektrischen Stromnetz und speziell in einem elektrischen Stromversorgungsnetz bzw. Stromverteilnetz zu verstehen, der zwischen seinem geschlossenen und seinem geöffneten, schaltkreisunterbrechenden Zustand gesteuert, insbesondere automatisiert durch eine zugeordnete Steuereinheit, umgeschaltet werden kann. Insbesondere gehören dazu alle Arten von Schaltern, mit denen in Stromverteilnetzen die beiden Schalteranschlussseiten gesteuert galvanisch getrennt und wieder verbunden werden können. Speziell umfasst der Begriff Trennschalter vorliegend neben Trennschaltern im engeren Sinn beispielsweise auch sogenannte Lastschalter, wie sie z.B. in Trafostationen von Verteilnetzen eingesetzt werden, und sogenannte Leistungsschalter, wie sie z.B. in Knotenpunkt- und Kundenstationen sowie in Stromeinspeisestationen eingesetzt werden.

Innerhalb der Verteilnetzstationen können die Netzabschnitte mit Lastschaltern, oftmals wie vorliegend als Trennschalter oder auch als Lasttrennschalter bezeichnet, getrennt oder zusammengeschlossen werden. Typischerweise sind mehrere Verteilnetzstationen in einer Strahlen- oder Ringnetzstruktur aneinandergereiht an ein oder mehrere Umspannwerke angeschlossen. In Ringnetzen besitzt jede Verteilnetzstation mindestens je ein Schaltfeld an einem Eingang und an einem Ausgang zum Ring sowie ein oder mehrere weitere Schaltfelder zu den Ortsnetztransformatoren, wobei die Speisung der jeweiligen Verteilnetzstation von beiden Seiten erfolgen kann. Moderne Verteilnetze werden vor allem als offene Ringnetze betrieben. Bei diesen sind die Verteilnetzstationen im normalen Betrieb üblicherweise in einem an einer Trennstelle offenen Ring aneinandergereiht, wobei die Trennstelle von einem geöffneten Trennschalter in einer der Verteilnetzstationen gebildet ist. Die Einspeisung erfolgt entweder vom selben Umspannwerk oder auch von verschiedenen Umspannwerken, wobei an der Trennstelle beide Spannungsquellen zur Verfügung stehen, im Normalfall aber nicht zusammengeschaltet sind.

Insbesondere wenn es sich um verschiedene Umspannwerke bzw. Spannungsquellen handelt, ist darauf zu achten, dass der Ring nur dann geschlossen wird, wenn die Spannungen aus den beiden Spannungsquellen hinsichtlich Frequenz und Phase hinreichend synchron und hinsichtlich ihrer Amplitude hinreichend gleich sind, da andernfalls beim Zuschalten bzw. Zusammenschalten ein Quasi-Kurzschlussereignis mit großen Ausgleichsströmen entstehen könnte. Dasselbe Problem würde bestehen, wenn die zweite Speisung, evtl. auch nur temporär, aus einem Notstromaggregat erfolgt. Wenn dieses Notstromaggregat nicht synchron zum Umspannwerk läuft, darf die Trennstelle ebenfalls nicht geschlossen werden.

Somit besteht in derartigen Anwendungen, in denen innerhalb von Verteilnetzstationen Netzabschnitte zusammengeschaltet werden sollen, deren elektrische Spannungen nicht zwingend synchron sind, d.h. hinsichtlich Frequenz und Phasenlage bzw. Phasenwinkel nicht zwingend hinreichend übereinstimmen, und nicht zwingend von hinreichend gleicher Spannungsamplitude sein müssen, da sie eventuell aus unterschiedlichen Quellen stammen oder aufgrund von Belastungen unterschiedliche Netzparameter aufweisen, ein Bedarf an einer spannungsabgleichenden Trennschaltersteuerung, welche die beteiligten Spannungen hinsichtlich Frequenz, Phasenlage und Amplitude abgleicht, d.h. erfasst und miteinander vergleicht, um abhängig davon den jeweiligen Trennschalter anzusteuern, insbesondere einen zuvor offenen Trennschalter zu schließen. Dieser Bedarf besteht z.B. bei der Schließung einer von einem offenen Trennschalter gebildeten Trennstelle, wenn die Trennstelle von zwei Umspannwerken gespeist wird oder wenn die Netzabschnitte auf beiden Seiten der Trennstelle unterschiedlich belastet sind oder Fehlerzustände aufweisen. Ferner besteht dieser Bedarf auch in Fällen, in denen ein Inselnetz, das z.B. aus einer Notstromversorgung oder einem dezentralen Einspeiser gespeist wird, mit dem übergelagerten Netz, das aus einem Umspannwerk gespeist wird, zusammengeschaltet werden soll, z.B. über einen sogenannten QU( Blindleistungs-Unterspannungs)-Schutz. So offenbart die Patentschrift DE 10 2011 075 353 B4 eine Umschaltung auf eine Reserve-Einspeisung bei erkanntem Ausfall einer Haupteinspeisung in einer Verteilnetzstation eines Verteilnetzes z.B. mit Ringnetzstruktur.

In der Patentschrift DE 10 2013 202 868 C5 wird zur Verringerung des Aufwands einer feldbezogenen Lastfluss- und/oder Fehlererfassung vorgeschlagen, nicht alle Schaltfelder einer Verteilnetzstation mit teuren, hochpräzisen Spannungsmesseinheiten auszurüsten, sondern nur eines dieser Felder, z.B. mit einem induktiven Spannungswandler oder einer Spannungsmesseinheit mit ohmschem Teiler, und die übrigen Felder mit kostengünstigeren, weniger präzisen Spannungsmesseinheiten, z.B. kapazitiven Spannungsmesseinheiten, auszustatten und letztere von Zeit zu Zeit in geeigneter Weise anhand der Präzisionsmessung durch die hochpräzise Spannungsmesseinheit zu kalibrieren.

Bei normalen Netzzusammenschaltungen mit von einem Umspannwerk gelieferten Spannungen ist es üblich, einen Phasenvergleich der Spannungen vor Ort durchzuführen, bevor ein Trennschalter auf eine Sammelschiene aufgeschaltet wird. Damit soll sichergestellt werden, dass eine korrekte Phasenzuordnung besteht und nicht während der Installation oder Wartungen Phasenfolgen vertauscht wurden. In der Regel findet dabei kein Amplitudenabgleich statt, da davon ausgegangen wird, dass die auf das gleiche Umspannwerk zurückgehenden Spannungen allenfalls unkritische Amplitudenabweichungen aufweisen und die üblicherweise vor Ort benutzten kapazitiven Spannungsmesseinheiten keine hochpräzise Spannungsmessung liefern. Zur Umsetzung dieser herkömmlichen Abgleichmaßnahmen vor Ort werden typischerweise sogenannte Feldleitgeräte verwendet, siehe z.B. die Feldleitgeräte der IKI-Linie der Kries-Elektrotechnik GmbH & Co. KG.

Herkömmlicherweise wird bei Schaltmaßnahmen, bei denen die Spannungsquelle umgeschaltet wird, meist die sog. Dunkelschaltungstechnik benutzt, bei der die Sammelschiene und damit der Kunde, der über den Ortsnetztransformator in der Verteilnetzstation versorgt wird, während der Umschaltung kurz ausgeschaltet wird, um zu vermeiden, dass zwei asynchrone oder zu stark unterschiedliche Spannungen auf der Sammelschiene zusammentreffen. Die Dunkelschaltungstechnik ist insbesondere bei der Rückschaltung von Notstrom auf Umspannwerk oder bei der Umschaltung von Haupt- auf Nebeneinspeisung oder von Neben- auf Haupteinspeisung üblich.

Des Weiteren sind in Nieder-, Mittel- und Hochspannungs-Verteilnetzen diverse Maßnahmen und Vorrichtungen zur Fehlerfrüherkennung gebräuchlich. So offenbart z.B. die Patentschrift DE 10 2020 214 614 B3 eine Schaltungsanordnung zur Spannungsprüfung und Teilentladungserfassung, mit der u.a. festgestellt werden kann, ob ein Schaltfeld einen Isolationsverlust aufweist, der sich in absehbarer Zeit zu einem Ausfall entwickeln könnte. Ferner sind zur Fehlerfrüherkennung Vorrichtungen zur Erkennung transienter Fehler bzw. intermittierender Erdschlüsse bekannt, die aus einer Strom- und/oder Spannungsmessung einen Isolationsfehler samt Richtung erkennen und damit feststellen können, ob ein vorgelagerter Netzabschnitt einen Kabelfehler aufweist, der sich in absehbarer Zeit zu einem Ausfall entwickeln könnte. Eine solche Vorrichtung ist beispielsweise in der Patentschrift DE 10 2012 209 019 B3 in Form einer speziellen Fehlererkennungs- und Fehlermeldeeinrichtung offenbart.

Weiterhin sind sog. QU-Schutzsysteme bzw. Überstromzeitschutzsysteme für dezentrale Einspeiser bekannt, die bei Abweichung bestimmter Parameter abgeschaltet werden und bei Wiedereinhaltung der Parameter auch automatisch wieder zugeschaltet werden. Hierbei werden sowohl auf der Seite der dezentralen Einspeiser als auch auf der Sammelschienenseite, auf die der dezentrale Einspeiser aufgeschaltet werden soll, für die Spannungsmessung klassische Wandler oder Präzisionssensoren angewandt, was entsprechend hohen Aufwand erfordert. Ein solches System ist z.B. das unter der Bezeichnung Siemens Siprotec 4 7Sj80 auf dem Markt befindliche Gerät.

Der Erfindung liegt als technisches Problem die Bereitstellung einer Vorrichtung der eingangs genannten Art zur spannungsabgleichenden Trennschaltersteuerung in einem Stromnetz und eines entsprechenden Verfahrens zugrunde, die gegenüber dem oben erwähnten Stand der Technik weitergehend verbessert sind und insbesondere eine verbesserte und vorzugsweise automatisierte Steuerung des Schließens des Trennschalters z.B. zum Zusammenschalten von nicht selbstverständlich synchronen und spannungsgleichen Netzen ohne Dunkelschaltungsmaßnahme mit relativ geringem Fertigungs- und Betriebsaufwand ermöglichen.

Die Erfindung löst dieses Problem durch die Bereitstellung einer Vorrichtung zur spannungsabgleichenden Trennschaltersteuerung mit den Merkmalen des Anspruchs 1 und eines Verfahrens zur spannungsabgleichenden Trennschaltersteuerung mit den Merkmalen des Anspruchs 9. Vorteilhafte Weiterbildungen der Erfindung sind Gegenstand der Unteransprüche, deren Wortlaut hiermit durch Verweis zum Bestandteil der Beschreibung gemacht wird. Dies schließt insbesondere auch alle Ausführungsformen der Erfindung ein, die sich aus den Merkmalskombinationen ergeben, die durch die Rückbezüge in den Unteransprüchen definiert sind.

Die erfindungsgemäße Vorrichtung dient zur vorzugsweise automatischen spannungsabgleichenden Trennschaltersteuerung in einem Stromnetz, insbesondere in einem Mittelspannungs-Verteilnetz, wobei das Stromnetz einen Trennschalter mit einer ersten Anschlussseite, die von einer ersten Spannung beaufschlagbar ist, und einer zweiten Anschlussseite aufweist, die von einer zweiten Spannung beaufschlagbar ist, und umfasst eine erste Spannungsmesseinheit, die zur zeitwiederholten Gewinnung einer ersten Messspannung durch eine Messung der ersten Spannung mit einer vorgegebenen ersten Messgenauigkeit eingerichtet ist, eine zweite Spannungsmesseinheit, die zur zeitwiederholten Gewinnung einer zweiten Messspannung durch eine Messung der zweiten Spannung mit einer vorgegebenen zweiten Messgenauigkeit eingerichtet ist, die geringer als die erste Messgenauigkeit ist, eine Kalibriereinheit, die zur Gewinnung einer kalibrierten zweiten Messspannung durch eine Kalibrierung der zweiten Messspannung mit der ersten Messspannung eingerichtet ist, und eine Schaltersteuerungseinheit, die zur Steuerung des Trennschalters eingerichtet ist und ein Schließen des Trennschalters von der Erfüllung einer oder mehrerer vorgegebener Zuschaltbedingungen abhängig macht, zu denen gehört, dass ein Amplitudendifferenzbetrag der zuletzt gewonnenen kalibrierten zweiten Messspannung und der zuletzt gewonnenen ersten Messspannung einen vorgegebenen Maximalamplitudendifferenzbetrag nicht überschreitet.

Analog dient das erfindungsgemäße Verfahren zur spannungsabgleichenden Trennschaltersteuerung in einem Stromnetz, insbesondere in einem Mittelspannungs-Verteilnetz, wobei das Stromnetz einen Trennschalter mit einer ersten Anschlussseite, die von einer ersten Spannung beaufschlagbar ist, und einer zweiten Anschlussseite aufweist, die von einer zweiten Spannung beaufschlagbar ist. Verfahrensgemäß werden zeitwiederholt eine erste Messspannung durch eine Messung der ersten Spannung mit einer vorgegebenen ersten Messgenauigkeit und eine zweite Messspannung durch eine Messung der zweiten Spannung mit einer vorgegebenen zweiten Messgenauigkeit, die niedriger als die erste Messgenauigkeit ist, sowie eine kalibrierte zweite Messspannung durch ein Kalibrieren der zweiten Messspannung mit der ersten Messspannung gewonnen. Der Trennschalter wird, vorzugsweise automatisiert, so gesteuert, dass sein Schließen von einem Erfüllen einer oder mehrerer vorgegebener Zuschaltbedingungen abhängig gemacht wird, zu denen gehört, dass eine Amplitudendifferenz der zuletzt gewonnenen kalibrierten zweiten Messspannung und der zuletzt gewonnenen ersten Messspannung eine vorgegebene Maximalamplitudendifferenz nicht überschreitet.

Unter der zeitwiederholten Gewinnung der betreffenden Messspannung ist dabei zu verstehen, dass die zugehörige Spannung in regelmäßigen oder unregelmäßigen Zeitabständen oder kontinuierlich gemessen wird. Die jeweilige Messgenauigkeit kann vom Typ der verwendeten Spannungsmesseinheit abhängen, wobei es sich bei der ersten Spannungsmesseinheit z.B. um eine hochpräzise Spannungsmesseinheit in Form eines induktiven Spannungswandlers oder einer Spannungsmesseinheit mit ohmschem Teiler handeln kann, während es sich bei der zweiten Spannungsmesseinheit z.B. um eine vergleichsweise einfache kapazitive Spannungsmesseinheit geringerer Messgenauigkeit handeln kann. Die erste Messgenauigkeit kann z.B. einem Messtoleranzbetrag von höchstens ca. 2% oder höchstens ca. 1% entsprechen, die zweite Messgenauigkeit einem Messtoleranzbetrag von z.B. ca. 10% oder ca. 20%. Mit anderen Worten kann die erste Messgenauigkeit z.B. um mindestens den Faktor 5 bis 10 höher sein als die zweite Messgenauigkeit.

Durch die Kalibrierung der zweiten Messspannung mit der ersten Messspannung lässt sich für die Ermittlung der zweiten Spannung eine Genauigkeit bereitstellen, die im Wesentlichen derjenigen der Genauigkeit der Ermittlung der ersten Spannung durch die präziser messende erste Spannungsmesseinheit entsprechen kann, obwohl die Messung der zweiten Spannung durch die zweite, weniger präzise messende Spannungsmesseinheit vorgenommen wird. Dies spart gegenüber einer Verwendung hochpräziser Spannungsmesseinheiten für die Messung beider Spannungen signifikanten Realisierungs- und Betriebsaufwand ein und ermöglicht trotzdem die Bereitstellung von Spannungsmesswerten für beide Spannungen mit im Wesentlichen der Genauigkeit der einen präziseren Spannungsmesseinheit. Die Einsparung an Aufwand wird noch signifikanter, wenn das Stromnetz mehrere erfindungsgemäß gesteuerte Trennschalter mit gemeinsamer erster Anschlussseite, z.B. an eine gemeinsame Sammelschiene, aufweist. Es kann in diesem Fall genügen, nur eine einzige erste, präzisere Spannungsmesseinheit vorzusehen, um die Spannung an der ersten Anschlussseite mit der höheren Messgenauigkeit zu bestimmen, und den zweiten Anschlussseiten der verschiedenen Trennschalter jeweils eine zweite Spannungsmesseinheit mit der geringeren Messgenauigkeit zuzuordnen.

Die erfindungsgemäße Vorrichtung und das erfindungsgemäße Verfahren beinhalten einen Spannungsabgleich oder genauer gesagt einen Spannungsamplitudenabgleich, indem das Schließen des Trennschalters von der Erfüllung einer oder mehrerer vorgegebener Zuschaltbedingungen abhängig macht wird, zu denen gehört, dass ein Amplitudendifferenzbetrag der zuletzt gewonnenen kalibrierten zweiten Messspannung und der zuletzt gewonnenen ersten Messspannung einen vorgegebenen Maximalamplitudendifferenzbetrag nicht überschreitet. Das gewährleistet überwachend, dass die zusammenzuschaltenden Spannungen hinreichend gleiche Spannungsamplituden besitzen, d.h. ihre Spannungsamplituden nicht über ein tolerierbares Maß hinaus voneinander abweichen. Bei der erfindungsgemäßen Vorrichtung übernimmt die entsprechend ausgelegte Schaltersteuerungseinheit selbsttätig diesen Spannungsabgleich und die davon abhängige Steuerung des Trennschalters. Damit ermöglichen die erfindungsgemäße Vorrichtung und das entsprechend ausgeführte erfindungsgemäße Verfahren eine automatisierte spannungsabgleichende Trennschaltersteuerung und speziell ein automatisiertes Schließen des Trennschalters unter Berücksichtigung des Spannungsabgleichs, wobei der Begriff automatisiert die alternativen Möglichkeiten umfasst, dass die Trennschaltersteuerung vollautomatisiert, d.h. unabhängig von einem Benutzereingriff vollständig selbsttätig, erfolgt oder in einer teilautomatisierten Ausführung, in welcher der Spannungsabgleich vom System, i.e. der verfahrensdurchführenden Vorrichtung, ohne Benutzermaßnahmen selbsttätig durchgeführt wird, die tatsächliche Schalterbetätigung jedoch eine Bestätigungshandlung vom Benutzer erfordert.

Die erfindungsgemäße Vorrichtung und das erfindungsgemäße Verfahren lassen sich beispielsweise für sogenannte Umschaltautomatiken verwenden, bei denen während eines Netzausfalls oder bei Vorliegen einer Fehlerfrüherkennung in einer Haupteinspeisung auf eine Reserve-Einspeisung umgeschaltet wird und bei Wiederverfügbarkeit der störungsfreien Haupteinspeisung bevorzugt ohne Dunkelschaltung die Umschaltung bzw. Rückschaltung auf die Haupteinspeisung erfolgen soll. Eine Dunkelschaltung und somit eine Unterbrechung der Stromversorgung beim Kunden lässt sich mit der erfindungsgemäßen Vorrichtung und dem erfindungsgemäßen Verfahren auch in Fällen vermeiden, in denen die aktuelle Einspeisung noch verfügbar ist und aufgrund von Lastmanagement-Aufgaben oder zur Fehlervermeidung auf eine andere Einspeisung umgeschaltet werden soll.

Die erfindungsgemäße Vorrichtung und das erfindungsgemäße Verfahren lassen sich unter anderem zur automatischen Zuschaltung eines spannungsbehafteten Abgangs auf eine spannungsbehaftete Sammelschiene in einem Verteilnetz, zur Zuschaltung eines offenen und beidseitig unter Spannung stehenden Trennschalters und auch gezielt zur Bewirkung eines Trigger-Ereignisses nutzen, um die unpräziser erfasste Spannung bei der Inbetriebnahme oder bei der Wartung des betreffenden Systems mit der Referenzspannung zu kalibrieren. Die automatische, spannungsabgleichende und bevorzugt auch synchrone Zuschaltung lässt sich des Weiteren dazu nutzen, Netzabschnitte z.B. zum Zwecke des Lastausgleichs oder der Topologie-Veränderung zusammenzuschalten. Dies ist insbesondere in sogenannten selbstheilenden Netzen von Nutzen. Die erfindungsgemäße Vorrichtung und das erfindungsgemäße Verfahren lassen sich auch bei der Zuschaltung von dezentralen Einspeisern an ein Mutternetz verwenden und können dort ebenfalls zu hohe Ausgleichsströme bzw. Fehlschaltungen verhindern.

In einer Weiterbildung der Erfindung gehört zu den Zuschaltbedingungen des Weiteren, dass eine vorgegebene Maximaldauer seit einer letzten Gewinnung der kalibrierten zweiten Messspannung noch nicht verstrichen ist. Damit lässt sich für Ausführungsvarianten, bei denen die Kalibrierung nicht kontinuierlich, sondern periodisch in gewissen Zeitabständen erfolgt, wie dies häufig erwünscht und hinsichtlich Betriebsaufwand vorteilhaft ist, eine zu große Abweichung der kalibrierten Messspannung von der wahren Spannung vermeiden, die dadurch verursacht sein könnte, dass sich die wahre Spannung seit dem letzten Kalibrierungszeitpunkt merklich verändert hat. Die Maximaldauer kann dabei je nach Bedarf und Anwendungsfall geeignet vorgegeben werden, z.B. auf einen Wert zwischen etwa 24 h und etwa 48 h.

In einer Weiterbildung der Erfindung gehört zu den Zuschaltbedingungen des Weiteren, dass eine Frequenzdifferenz der zuletzt gewonnenen kalibrierten zweiten Messspannung und der zuletzt gewonnenen ersten Messspannung eine vorgegebene Maximalfrequenzdifferenz nicht überschreitet und/oder dass eine Phasendifferenz der zuletzt gewonnenen kalibrierten zweiten Messspannung und der zuletzt gewonnenen ersten Messspannung eine vorgegebene Maximalphasendifferenz nicht überschreitet. Dadurch ist vorteilhaft eine entsprechende Synchronitätsprüfung mit vorgebbarer Maximaltoleranz hinsichtlich Frequenz und/oder Phasenlage in die erfindungsgemäße Vorrichtung bzw. das erfindungsgemäße Verfahren integriert.

In einer Weiterbildung der Erfindung ist die Vorrichtung zur Verwendung in einer Verteilnetzstation eines Nieder-, Mittel- oder Hochspannungs-Verteilnetzes eingerichtet, die eine Sammelschiene und mehrere daran parallel über einen jeweiligen Trennschalter angekoppelte Schaltfelder umfasst, von denen ein erstes ein Ortsnetztransformator-Schaltfeld ist und ein zweites ein anderes Schaltfeld ist, wobei die erste Spannungsmesseinheit zur Ankopplung an die Sammelschiene oder an das Ortsnetztransformator-Schaltfeld eingerichtet ist und die zweite Spannungsmesseinheit zur Ankopplung an das zweite Schaltfeld eingerichtet ist.

In derartigen Anwendungen erfüllen die erfindungsgemäße Vorrichtung und das erfindungsgemäße Verfahren z.B. die Funktion einer automatischen, synchronen Zuschaltung eines jeweiligen Verteilnetz-Trennschalters auf eine unter Spannung stehende Sammelschiene. Dies kann auch zum Zweck der erwähnten Kalibrierung erfolgen, indem in gewissen Zeitabschnitten geöffnete Trennschalter, z.B. zur Realisierung einer Trennstelle in einer Ringnetzstruktur, mit beidseitig anliegender Spannung unter Einhaltung einer Zuschaltbedingung auf die Sammelschiene aufschaltet werden, um die weniger präzise gemessene Spannung vor dem Trennschalter, d.h. auf der der Sammelschiene abgewandten Anschlussseite, mit der präziser gemessenen Spannung, auch Referenzspannung bezeichnet, hinter dem Trennschalter, d.h. auf der der Sammelschiene zugewandten Seite, zu kalibrieren.

Der Spannungsabgleich und optional auch eine Synchronitätsbedingung erfolgen vorzugsweise in Bezug zur Referenzspannung, indem in jedem Schaltfeld ein Spannungsabgleich, d.h. Spannungsvergleich, mit der Referenzspannung durchgeführt werden, wobei die Referenzspannungsmessung z.B. mit einem Präzisionsteiler als Spannungsmesseinheit ausgeführt wird, während die sonstige Spannungsmessung in den Schaltfeldern über kapazitive Spannungsmesseinheiten mit geringerer Genauigkeit erfolgt. Bei den Anwendungen in Verteilnetzstationen ist die Sammelschiene selbst meist nicht zugänglich, so dass in diesem Fall die Referenzspannungsmessung in einem Schaltfeld durchgeführt wird, das mit einer großen Wahrscheinlichkeit zugeschaltet ist. Dies ist vorzugsweise das Feld mit dem Ortsnetztransformator. Sind die Spannungsgleichheit und die Synchronität in den gewünschten Grenzen gewährleistet, kann eine vorzugsweise automatische Zuschaltung für unterschiedliche Zwecke erfolgen, z.B. für eine Umschaltautomatik, einen Netz-Lastausgleich, einen Netzaufbau, eine Wiederzuschaltung von dezentralen oder Notstrom-Einspeisern und/oder die Kalibrierung der Spannungsmessung. Dies wirkt sich z.B. bei einer Umschaltautomatik dahingehend vorteilhaft aus, dass die Sammelschiene bei der Rückschaltung von Reserveeinspeisung auf Haupteinspeisung nicht mehr spannungsfrei geschaltet werden muss und eine Dunkelschaltung vermieden werden kann.

In einer Ausgestaltung der Erfindung weist die Verteilnetzstation außer dem ersten Schaltfeld mehrere zweite Schaltfelder auf, wobei die Vorrichtung je eine zweite Spannungsmesseinheit zur Ankopplung an je eines der zweiten Schaltfelder aufweist und die Schaltersteuerungseinheit dafür eingerichtet ist, ein Schließen des jeweiligen Trennschalters der zweiten Schaltfelder von der Erfüllung der zugehörigen Zuschaltbedingungen abhängig zu machen. Die Verwendung der weniger präzise messenden Spannungsmesseinheiten für die zweiten Schaltfelder minimiert vorteilhaft den Realisierungs- und Betriebsaufwand.

In einer anderen Ausgestaltung der Erfindung umfasst die Vorrichtung eine Teilentladungserkennungseinrichtung, die zur Teilentladungserkennung im zweiten Schaltfeld eingerichtet ist, und zu den Zuschaltbedingungen für den zugehörigen Trennschalter gehört, dass ein von der Teilentladungserkennungseinrichtung erfasster Teilentladungspegel einen vorgegebenen Maximalteilentladungspegel nicht überschreitet. Damit ist vorteilhaft eine Teilentladungserkennung und deren Nutzung für die Entscheidung, ob der Trennschalter geschlossen werden kann, in die erfindungsgemäße Vorrichtung bzw. das erfindungsgemäße Verfahren integriert.

In einer anderen Ausgestaltung der Erfindung umfasst die Vorrichtung eine Erdschlusserkennungseinrichtung, die zur Erkennung eines intermittierenden Erdschlusses im zweiten Schaltfeld eingerichtet ist, und zu den Zuschaltbedingungen für den zugehörigen Trennschalter gehört, dass die Erdschlusserkennungseinrichtung keinen intermittierenden Erdschluss erkannt hat. Damit ist vorteilhaft eine Erkennung intermittierender Erdschlüsse und deren Nutzung für die Entscheidung, ob der Trennschalter geschlossen werden kann, in die erfindungsgemäße Vorrichtung bzw. das erfindungsgemäße Verfahren integriert.

In einer Weiterbildung der Erfindung weist die Vorrichtung eine extern ansteuerbare Deaktivierungseinheit zur Deaktivierung der Trennschaltersteuerungsfunktion der Schaltersteuerungseinheit auf. Damit lässt sich diese Steuerungsfunktion auf Wunsch durch den Benutzer z.B. vor Ort oder über eine Fernwirktechnik deaktivieren, z.B. um für den Benutzer unerwartete Schalthandlungen dieser Funktionalität in Wartungsfällen zu verhindern.

In einer Weiterbildung der Erfindung wird das erfindungsgemäße Verfahren durch die erfindungsgemäße Vorrichtung durchgeführt, was eine bevorzugte Verfahrensrealisierung darstellt.

Vorteilhafte Ausführungsformen der Erfindung sind in den Zeichnungen dargestellt. Diese und weitere Ausführungsformen der Erfindung werden nachfolgend näher beschrieben. Hierbei zeigen:
- Fig. 1: eine schematische Blockdiagrammdarstellung eines hier interessierenden Teils eines Stromnetzes mit Verteilnetzstationen in einer offenen Ringnetzstruktur,
- Fig. 2: eine schematische Blockdiagrammdarstellung einer der Verteilnetzstationen von Fig. 1 mit implementierter erfindungsgemäßer Vorrichtung zur spannungsabgleichenden Trennschaltersteuerung und
- Fig. 3: ein Flussdiagramm eines erfindungsgemäßen Verfahrens zur spannungsabgleichenden Trennschaltersteuerung.

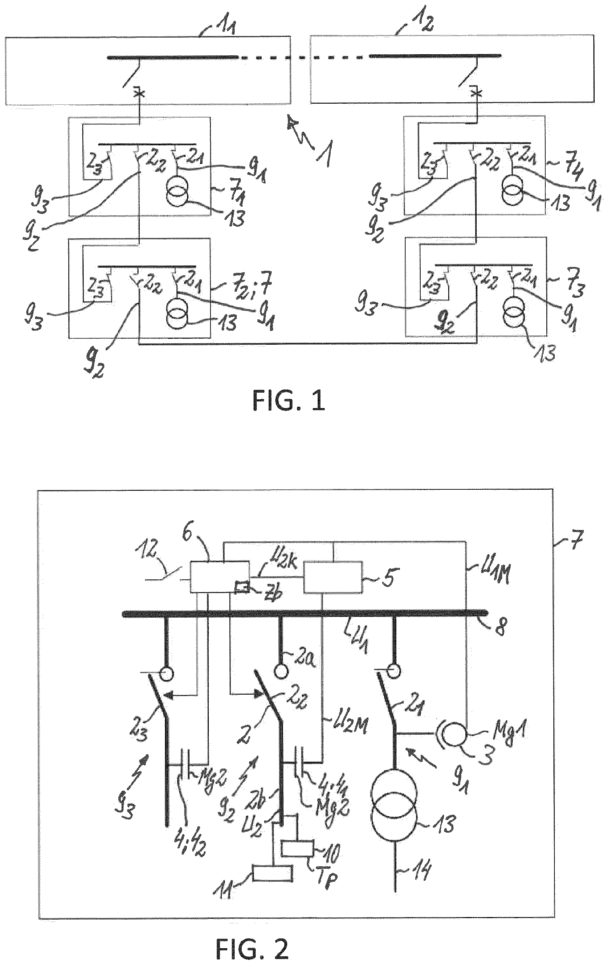

Die Fig. 1 und 2 zeigen die Verwendung einer erfindungsgemäßen Vorrichtung in einem Stromnetz 1, bei dem es sich insbesondere um ein Mittelspannungs-Verteilnetz, alternativ um ein Nieder- oder Hochspannungsverteilnetz, handeln kann und das in einer üblichen Weise u.a. einen Trennschalter 2 mit einer ersten Anschlusseite 2a, die von einer ersten Spannung U₁ beaufschlagbar ist, und einer zweiten Anschlussseite 2b aufweist, die von einer zweiten Spannung U₂ beaufschlagbar ist, wie aus Fig. 2 ersichtlich.

Im gezeigten Beispiel ist der Trennschalter 2 Bestandteil einer Verteilnetzstation 7 von mehreren Verteilnetzstationen 7₁, 7₂, 7₃, 7₄ des Verteilnetzes, hier z.B. Bestandteil der Verteilnetzstation 7₂. Vom Stromnetz 1 sind des Weiteren schematisch ein erstes Umspannwerk 1₁ und ein zweites Umspannwerk 1₂ gezeigt, wobei es sich alternativ auch um ein einziges Umspannwerk mit zwei Abgängen handeln kann. Die Verteilnetzstationen 7₁, 7₂, 7₃, 7₄ beinhalten jeweils in üblicher Weise eine Sammelschiene 8 und sind in einer offenen Ringnetzstruktur an die Umspannwerke 1₁, 1₂ angekoppelt, wobei der Trennschalter 2 der Verteilnetzstation 7₂ die Trennstelle des Rings bildet. Die Verteilnetzstationen 7₁, 7₂, 7₃, 7₄ können einen grundsätzlich gleichartigen Aufbau besitzen, wobei sie u.a. jeweils ein Ortsnetztransformator-Schaltfeld 9₁ mit zugehörigem Trennschalter 2₁, Ortsnetztransformator 13 und Kundenabgang 14, siehe Fig. 2, ein eingangsseitiges Schaltfeld 9s mit zugehörigem Trennschalter 2₃ und ein ausgangsseitiges Schaltfeld 9₂ mit zugehörigem Trennschalter 2₂ umfassen.

Die Komponenten und der Aufbau der erfindungsgemäßen Vorrichtung in einer vorteilhaften Realisierung sind in Verwendung an der Verteilnetzstation 7 aus Fig. 2 näher ersichtlich. Demgemäß umfasst die erfindungsgemäße Vorrichtung eine erste Spannungsmesseinheit 3, die zur zeitwiederholten Gewinnung einer ersten Messspannung U_{1M} durch eine Messung der ersten Spannung U₁ mit einer vorgegebenen ersten Messgenauigkeit Mg1 eingerichtet ist. Die erste Spannungsmesseinheit 3 kann z.B. ein induktiver Spannungswandler oder eine Spannungsmesseinheit mit ohmschem Teiler sein und erlaubt eine relativ präzise Spannungsmessung, wobei die erste Messgenauigkeit Mg1 z.B. ca. 1 % betragen kann. Im gezeigten Beispiel ist die zu erfassende erste Spannung U₁ die an der Sammelschiene 8 anliegende Spannung. Da die Sammelschiene 8 selbst üblicherweise zum Anordnen derartiger Messgeräte nicht zugänglich ist, ist die erste Spannungsmesseinheit 3 im Ortsnetztransformator-Schaltfeld 9₁ angeordnet, das typischerweise bis auf Sondersituationen in den meisten Zeiträumen der Sammelschiene 8 zugeschaltet ist, d.h. der betreffende Trennschalter 2₁ ist mit größerer Wahrscheinlichkeit geschlossen als die anderen Trennschalter 2₂ und 2₃ und die Spannung am Eingang des Ortsnetztransformator-Schaltfeldes 9₁ entspricht daher dann der gesuchten Sammelschienen-Spannung.

Weiter umfasst die erfindungsgemäße Vorrichtung eine zweite Spannungsmesseinheit 4, die zur zeitwiederholten Gewinnung einer zweiten Messspannung U_{2M} durch eine Messung der zweiten Spannung U₂ mit einer vorgegebenen zweiten Messgenauigkeit Mg2 eingerichtet ist, die geringer als die erste Messgenauigkeit Mg1 ist. Die zweite Spannungsmesseinheit 4 kann z.B. eine weniger präzise messende kapazitive Spannungsmesseinheit sein, wobei die zweite Messgenauigkeit Mg2 z.B. ca. 20 % betragen kann. Im gezeigten Beispiel sind dem eingangsseitigen Schaltfeld 9₃ und dem ausgangsseitigen Schaltfeld 9₂ je eine zweite Spannungsmesseinheit 4₁, 4₂ zugeordnet.

Die erfindungsgemäße Vorrichtung weist zudem eine Kalibriereinheit 5 auf, die zur Gewinnung einer kalibrierten zweiten Messspannung U₂ₖ durch eine Kalibrierung der zweiten Messspannung U_{2M} mit der ersten Messspannung U_{1M} eingerichtet ist. Die Durchführung des Kalibriervorgangs kann an das Vorliegen vorgegebener Kalibrierbedingungen geknüpft sein. Beispielsweise kann vorgesehen sein, eine Kalibrierung nur durchzuführen, wenn die erste Messspannung U_{1M} zu einem Zeitpunkt gewonnen wurde, zu welcher der zugehörige Trennschalter 2₁ geschlossen war, d.h. eine galvanische Verbindung vom Messpunkt der ersten Spannungsmesseinheit 3 zur Sammelschiene 8 bestand. Hierfür wird in diesem Fall der Schaltzustand dieses Trennschalters 2₁ entsprechend überwacht. Die Kalibriereinheit 5 und das zugehörige Kalibrierverfahren können von irgendeinem herkömmlichen Typ sein, wie er zur Erfüllung dieser Funktionalität an sich bekannt ist, was daher hier keiner näheren Erläuterungen bedarf. Beispielsweise kann als Kalibriereinheit 5 eine solche verwendet werden, wie sie in der oben erwähnten DE 10 2013 202 868 C5 offenbart ist, dort als Auswerteeinheit bezeichnet.

Des Weiteren beinhaltet die erfindungsgemäße Vorrichtung eine Schaltersteuerungseinheit 6, die zur Steuerung des Trennschalters 2 eingerichtet ist und ein Schließen des Trennschalters 2 von der Erfüllung einer oder mehrerer vorgegebener Zuschaltbedingungen Zb abhängig macht, zu denen gehört, dass ein Amplitudendifferenzbetrag AU_{D} = ||U₂ₖ| - |U_{1M}|| der zuletzt gewonnenen kalibrierten zweiten Messspannung U₂ₖ und der zuletzt gewonnenen ersten Messspannung U_{1M} einen vorgegebenen Maximalamplitudendifferenzbetrag AUₘₐₓ nicht überschreitet, d.h. AU_{D} ≤ AUₘₐₓ. Dazu sind in der Schaltersteuerungseinheit 6 der zugehörige Spannungsabgleichalgorithmus und die Zuschaltbedingungen Zb implementiert, und der Schaltersteuerungseinheit 6 werden die betreffenden Informationen, d.h. die kalibrierte zweite Messspannung U₂ₖ und die erste Messspannung U_{1M}, zugeführt. Der Maximalamplitudendifferenzbetrag AUₘₐₓ kann je nach Bedarf geeignet vorgegeben werden, z.B. derart, dass eine Abweichung des Betrags ||U₂ₖ| - |U_{1M}|| der Differenz |U₂ₖ| - |U_{1M}| der Beträge |U₂ₖ|, |U_{1M}| der beiden Spannungen U₂ₖ, U_{1M} von höchstens 10 % des Betrages |U_{1M}| der ersten Messspannung U_{1M} zugelassen wird. Vorzugsweise sind in der Schaltersteuerungseinheit 6 weitere, herkömmliche Schaltersteuerungsmaßnahmen implementiert, wie sie zur Trennschaltersteuerung an sich bekannt sind, was hier keiner weiteren Erläuterungen bedarf. Die Schaltersteuerungseinheit 6 ist damit in der Lage, die Trennschalter 2₂, 2s im ausgangsseitigen und im eingangsseitigen Schaltfeld 9₂, 9₃ entsprechend zu steuern.

In bevorzugten Ausführungsformen beinhalten die in der Schaltersteuerungseinheit 6 implementierten Zuschaltbedingungen Zb zudem die Bedingung, dass eine vorgegebene Maximaldauer tₘₐₓ seit einer letzten Gewinnung der kalibrierten zweiten Messspannung U₂ₖ noch nicht verstrichen ist. Dies trägt dazu bei, dass mit sehr hoher Wahrscheinlichkeit die aktuell vorliegende kalibrierte zweite Messspannung U₂ₖ der gesuchten, aktuell tatsächlich vorliegenden zweiten Spannung U₂ bestmöglich entspricht und sich die zweite Spannung U₂ seit dem letzten Kalibriervorgang nicht signifikant verändert hat. Dazu wird die Maximaldauer tₘₐₓ je nach Anwendungsfall geeignet vorgegeben, z.B. auf tₘₐₓ = 24 h oder tₘₐₓ = 48 h oder einen anderen passenden Wert kleiner als 24 h oder größer als 48 h oder zwischen 24 h und 48 h.

In bevorzugten Ausführungsformen beinhalten die in der Schaltersteuerungseinheit 6 implementierten Zuschaltbedingungen Zb des Weiteren die Bedingung, dass eine Frequenzdifferenz FU_{D} der zuletzt gewonnenen kalibrierten zweiten Messspannung U₂ₖ und der zuletzt gewonnenen ersten Messspannung U_{1M} eine vorgegebene Maximalfrequenzdifferenz FUₘₐₓ betraglich nicht überschreitet, d.h. der Betrag IFUol der Differenz FU_{D} der Frequenz der zweiten Messspannung U₂ₖ und der Frequenz der ersten Messspannung U_{1M} darf die Maximalfrequenzdifferenz FUₘₐₓ nicht übersteigen. Die Maximalfrequenzdifferenz FUₘₐₓ kann je nach Anwendungsfall geeignet vorgegeben werden, z.B. auf höchstens 10 % der Frequenz der ersten Messspannung U_{1M}.

In bevorzugten Ausführungsformen beinhalten die in der Schaltersteuerungseinheit 6 implementierten Zuschaltbedingungen Zb außerdem die Bedingung, dass eine

Phasendifferenz PU_{D} der zuletzt gewonnenen kalibrierten zweiten Messspannung U₂ₖ und der zuletzt gewonnenen ersten Messspannung U_{1M} eine vorgegebene Maximalphasendifferenz PUₘₐₓ betraglich nicht überschreitet, d.h. der Betrag |PU_{D}| der Differenz PU_{D} des Phasenwinkels der zweiten Messspannung U₂ₖ und des Phasenwinkels der ersten Messspannung U_{1M} darf die Maximalphasendifferenz PUₘₐₓ nicht übersteigen. Die Maximalphasendifferenz PUₘₐₓ kann je nach Anwendungsfall geeignet vorgegeben werden, z.B. auf höchstens 15 % des theoretisch maximal möglichen Phasenwinkelunterschieds.

In vorteilhaften Realisierungen beinhaltet die erfindungsgemäße Vorrichtung, wie im gezeigten Beispiel, außerdem eine Teilentladungserkennungseinrichtung 10, die zur Teilentladungserkennung im zweiten Schaltfeld 9₂ eingerichtet ist. Zu den Zuschaltbedingungen für den zugehörigen Trennschalter 2 bzw. 2₂ gehört in diesem Fall zusätzlich, dass ein von der Teilentladungserkennungseinrichtung 10 erfasster Teilentladungspegel Tp einen vorgegebenen Maximalteilentladungspegel Tpm nicht überschreitet, der je nach Anwendungsfall geeignet vorgegeben werden kann, d.h. es wird überwacht, ob Tp ≤ Tpm bleibt. Die Teilentladungserkennungseinrichtung 10 kann von irgendeinem herkömmlichen Typ sein, wie er zur Erfüllung dieser Funktionalität an sich bekannt ist, was daher hier keiner näheren Erläuterungen bedarf. Für die Teilentladungserkennungseinrichtung 10 kann beispielsweise eine solche verwendet werden, wie sie in der oben erwähnten DE 10 2020 214 614 B3 offenbart ist.

In vorteilhaften Ausführungen beinhaltet die erfindungsgemäße Vorrichtung, wie im gezeigten Beispiel, des Weiteren eine Erdschlusserkennungseinrichtung 11, die zur Erkennung eines intermittierenden Erdschlusses im zweiten Schaltfeld 9₂ eingerichtet ist. Zu den Zuschaltbedingungen (Zb) für den zugehörigen Trennschalter 2 bzw. 2₂ gehört in diesem Fall zusätzlich, dass die Erdschlusserkennungseinrichtung 11 keinen intermittierenden Erdschluss erkannt hat. Die Erdschlusserkennungseinrichtung 11 kann von irgendeinem herkömmlichen Typ sein, wie er zur Erfüllung dieser Funktionalität an sich bekannt ist, was daher hier keiner näheren Erläuterungen bedarf. Für die Erdschlusserkennungseinrichtung 11 kann beispielsweise eine solche verwendet werden, wie sie in der oben erwähnten DE 10 2012 209 019 B3 offenbart ist.

In vorteilhaften Ausführungen weist die erfindungsgemäße Vorrichtung, wie im gezeigten Beispiel, eine extern ansteuerbare Deaktivierungseinheit 12 zur Deaktivierung der Trennschaltersteuerungsfunktion der Schaltersteuerungseinheit 6 auf. Durch Betätigen der Deaktivierungseinheit 12 kann der Benutzer die Schaltersteuerungseinheit 6 in ihrer Trennschaltersteuerungsfunktion deaktivieren, z.B. wenn er sich in einem Wartungsfall vor entsprechenden unerwarteten, selbsttätigen Schalthandlungen der Schaltersteuerungseinheit 6 schützen will. Der Benutzer kann dann zu einem gewünschten Zeitpunkt durch Rückbetätigen der Deaktivierungseinheit 12 die Schaltersteuerungseinheit 6 in ihrer Trennschaltersteuerungsfunktion wieder aktivieren. Das Betätigen der Deaktivierungseinheit 12 kann je nach Bedarf und Anwendungsfall z.B. durch den Benutzer vor Ort oder über eine Fernwirktechnik von einem räumlich entfernten Ort erfolgen.

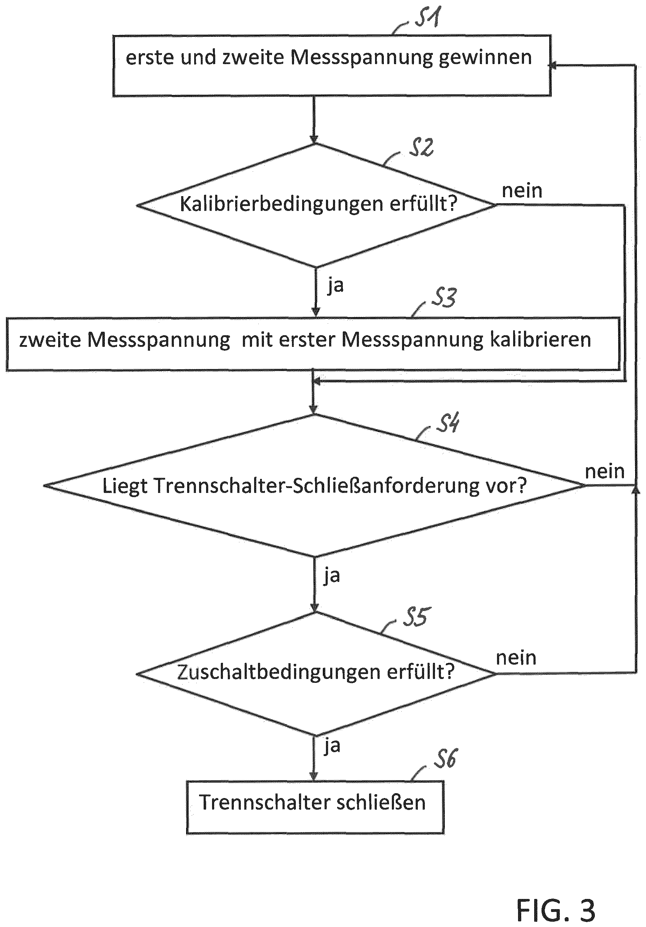

Fig. 3 veranschaulicht eine exemplarische Realisierung des erfindungsgemäßen Verfahrens, wie es zur spannungsabgleichenden Trennschaltersteuerung beispielsweise im Stromnetz 1 gemäß Fig. 1 durch die oben zu den Fig. 1 und 2 erläuterte erfindungsgemäße Vorrichtung ausführbar ist. In einem ersten Schritt S1 werden zeitwiederholt, d.h. in regelmäßigen oder unregelmäßigen Zeitabständen periodisch wiederholt oder kontinuierlich, die erste Messspannung U_{1M} mit der vorgegebenen ersten Messgenauigkeit Mg1 und die zweite Messspannung U_{2M} mit einer vorgegebenen zweiten Messgenauigkeit Mg2 gewonnen, die niedriger als die erste Messgenauigkeit Mg1 ist.

In einem nächsten Schritt S2 wird geprüft, ob vorgegebene Kalibrierbedingungen vorliegen. Im Anwendungsfall des Stromnetzes der Fig. 1 und 2 kann z.B. als Kalibrierbedingung vorgegeben werden, dass der Trennschalter 2₁ geschlossen ist, d.h. eine galvanische Verbindung zwischen dem Messpunkt der ersten Spannungsmesseinheit 3 und der Sammelschiene 8 vorliegt. Gegebenenfalls wird der betreffende Trennschalter 2₁ hierfür während des Kalibrierungszeitraums geschlossen, falls er zuvor geöffnet war und das Schließen nicht gegen andere Bedingungen verstößt. Nur wenn die Kalibrierbedingungen vorliegen, wird in einem anschließenden Schritt S3 die zweite Messspannung U_{2M} mit der ersten Messspannung U_{1M} kalibriert und auf diese Weise die kalibrierte zweite Messspannung U₂ₖ gewonnen. Dieser Kalibriervorgang wird je nach Bedarf periodisch in regelmäßigen oder unregelmäßigen Zeitabständen wiederholt, damit die kalibrierte zweite Messspannung U₂ₖ möglichst aktuell bleibt.

In einem Schritt S4 wird dann geprüft, ob für den verfahrensgemäß zu steuernden Trennschalter 2 eine zugehörige Schließanforderung vorliegt, d.h. eine z.B. von der Schaltersteuerungseinheit 6 erfasste Information ansteht, dass der momentan geöffnete Trennschalter 2 geschlossen werden soll. Im Fall der Fig. 1 und 2 kann dies beispielsweise dazu dienen, die vom offenen Trennschalter 2₂ gebildete Trennstelle der Ringnetzstruktur zu schließen und dadurch einen Ausfall z.B. der Ankopplung der Verteilnetzstation 7₁ an das Umspannwerk 1₁ zu kompensieren. Solange keine Schließanforderung vorliegt, bleibt der Trennschalter 2 geöffnet, und der Verfahrensablauf kann erneut bis zu diesem Verfahrensstadium durchlaufen werden.

Sobald das Vorliegen einer Trennschalter-Schließanforderung erkannt wird, wird in einem Schritt S5 geprüft, ob die vorgegebenen Zuschaltbedingungen Zb vorliegen. Die Prüfung der Zuschaltbedingungen Zb kann z.B. durch die Schaltersteuerungseinheit 6 erfolgen und umfasst, wie oben erläutert, den Amplitudenabgleich und optional auch den Frequenzabgleich und/oder den Phasenabgleich der zuletzt gewonnenen kalibrierten zweiten Messspannung U₂ₖ und der zuletzt gewonnenen ersten Messspannung U_{1M}. Der Amplitudenabgleich umfasst, wie oben bereits erläutert, die Prüfung, ob die Amplitudendifferenz AU_{D} der zuletzt gewonnenen kalibrierten zweiten Messspannung U₂ₖ und der zuletzt gewonnenen ersten Messspannung U_{1M} eine vorgegebene Maximalamplitudendifferenz AUₘₐₓ betraglich nicht überschreitet. Weiter können die Zuschaltbedingungen Zb vorzugsweise die Bedingung enthalten, dass der letzte Kalibriervorgang für die kalibrierte zweite Messspannung U₂ₖ noch nicht zu lange her ist, d.h. die vorgegebene Maximaldauer seit der letzten Kalibrierung noch nicht verstrichen ist.

Wenn die Zuschaltbedingungen Zb nicht erfüllt sind, z.B. weil die zuletzt gewonnene kalibrierte zweite Messspannung U₂ₖ und die zuletzt gewonnene erste Messspannung U_{1M} in ihrer Amplitude, Frequenz oder Phasenlage zu stark voneinander abweichen oder weil die kalibrierte zweite Messspannung U₂ₖ nicht ausreichend aktuell ist, wird der Trennschalter 2 nicht geschlossen und der Verfahrensablauf kann erneut bis zu diesem Verfahrensstadium durchlaufen werden. Nur wenn festgestellt wurde, dass die Zuschaltbedingungen Zb erfüllt sind, wird der Trennschalter 2 in seine Schließstellung gesteuert, beispielsweise durch einen entsprechenden, von der Schaltersteuerungseinheit 6 bewirkten Schließsteuerbefehl.

Wie die gezeigten und die weiteren oben erläuterten Ausführungsbeispiele deutlich machen, stellt die Erfindung eine Vorrichtung und ein Verfahren zur spannungsabgleichenden Steuerung eines Trennschalters in einem Stromnetz, insbesondere in einem Nieder-, Mittel- oder Hochspannungs-Verteilnetz, zur Verfügung, durch die insbesondere ein Schließen des Trennschalters unter Beachtung der Amplituden der beteiligten Spannungen in vorteilhafter Weise automatisiert mit relativ geringem Schaltungs- bzw. Fertigungsaufwand und Betriebsaufwand erfolgen kann. Dunkelschaltungen können hierbei vermieden werden.

Durch die Vorrichtung und das Verfahren der Erfindung ist ein System geschaffen, das es ermöglicht, Netzabschnitte von Stromversorgungsnetzen vorzugsweise automatisiert zusammenzuschalten, ohne dass durch Bedienpersonen manuell ein Amplituden-, Frequenz- und/oder Phasenabgleich durchgeführt werden muss, wobei Schaltfehler und Kurzschlussströme vermieden werden. Die Vorrichtung und das Verfahren können selbsttätig die Spannungssynchronität bzw. Spannungsgleichheit überwachen, deren Zuverlässigkeit durch die präzise Referenzspannungsmessung überprüfen und die weniger präzis gemessene Spannung zu bestimmten Zeitpunkten zwangskalibrieren.

## Patentansprüche

1. Vorrichtung zur spannungsabgleichenden Trennschaltersteuerung in einem Stromnetz (1), insbesondere in einem Mittelspannungs-Verteilnetz, wobei das Stromnetz (1) einen Trennschalter (2) mit einer ersten Anschlussseite (2a), die von einer ersten Spannung (U₁) beaufschlagbar ist, und einer zweiten Anschlussseite (2b) aufweist, die von einer zweiten Spannung (U₂) beaufschlagbar ist, wobei die Vorrichtung umfasst:
- eine erste Spannungsmesseinheit (3), die zur zeitwiederholten Gewinnung einer ersten Messspannung (U_{1M}) durch eine Messung der ersten Spannung (U₁) mit einer vorgegebenen ersten Messgenauigkeit (Mg1) eingerichtet ist,
- eine zweite Spannungsmesseinheit (4), die zur zeitwiederholten Gewinnung einer zweiten Messspannung (U_{2M}) durch eine Messung der zweiten Spannung (U₂) mit einer vorgegebenen zweiten Messgenauigkeit (Mg2) eingerichtet ist, die geringer als die erste Messgenauigkeit (Mg1) ist,
- eine Kalibriereinheit (5), die zur Gewinnung einer kalibrierten zweiten Messspannung (U₂ₖ) durch eine Kalibrierung der zweiten Messspannung (U_{2M}) mit der ersten Messspannung (U_{1M}) eingerichtet ist, und
- eine Schaltersteuerungseinheit (6), die zur Steuerung des Trennschalters (2) eingerichtet ist und ein Schließen des Trennschalters (2) von der Erfüllung einer oder mehrerer vorgegebener Zuschaltbedingungen (Zb) abhängig macht, zu denen gehört, dass ein Amplitudendifferenzbetrag (AU_{D}) der zuletzt gewonnenen kalibrierten zweiten Messspannung (U₂ₖ) und der zuletzt gewonnenen ersten Messspannung (U_{1M}) einen vorgegebenen Maximalamplitudendifferenzbetrag (AUₘₐₓ) nicht überschreitet.

2. Vorrichtung nach Anspruch 1, wobei zu den Zuschaltbedingungen des Weiteren gehört, dass eine vorgegebene Maximaldauer (tₘₐₓ) seit einer letzten Gewinnung der kalibrierten zweiten Messspannung (U₂ₖ) noch nicht verstrichen ist.

3. Vorrichtung nach Anspruch 1 oder 2, wobei zu den Zuschaltbedingungen des Weiteren gehört, dass eine Frequenzdifferenz (FU_{D}) der zuletzt gewonnenen kalibrierten zweiten Messspannung (U₂ₖ) und der zuletzt gewonnenen ersten Messspannung (U_{1M}) eine vorgegebene Maximalfrequenzdifferenz (FUₘₐₓ) betraglich nicht überschreitet und/oder dass eine Phasendifferenz (PU_{D}) der zuletzt gewonnenen kalibrierten zweiten Messspannung (U₂ₖ) und der zuletzt gewonnenen ersten Messspannung (U_{1M}) eine vorgegebene Maximalphasendifferenz (PUₘₐₓ) betraglich nicht überschreitet.

4. Vorrichtung nach einem der Ansprüche 1 bis 3, wobei sie zur Verwendung in einer Verteilnetzstation (7) eines Nieder-, Mittel- oder Hochspannungs-verteilnetzes eingerichtet ist, die eine Sammelschiene (8) und mehrere daran parallel über einen jeweiligen Trennschalter (2₁, 2₂, 2₃) angekoppelte Schaltfelder (9) umfasst, von denen ein erstes ein Ortsnetztransformator-Schaltfeld (9₁) ist und ein zweites ein anderes Schaltfeld (9₂) ist, wobei die erste Spannungsmesseinheit (3) zur Ankopplung an die Sammelschiene (8) oder an das Ortsnetztransformator-Schaltfeld (9₁) eingerichtet ist und die zweite Spannungsmesseinheit (4) zur Ankopplung an das zweite Schaltfeld (9₂) eingerichtet ist.

5. Vorrichtung nach Anspruch 4, wobei die Verteilnetzstation (7) außer dem ersten Schaltfeld (9₁) mehrere zweite Schaltfelder (9₂, 9s) aufweist, die Vorrichtung je eine zweite Spannungsmesseinheit (4₁, 4₂) zur Ankopplung an je eines der zweiten Schaltfelder (9₂, 9s) aufweist und die Schaltersteuerungseinheit (6) dafür eingerichtet ist, ein Schließen des jeweiligen Trennschalters (2₂, 2₃) der zweiten Schaltfelder (9₂, 9s) von der Erfüllung der zugehörigen Zuschaltbedingungen abhängig zu machen.

6. Vorrichtung nach Anspruch 4 oder 5, wobei sie eine Teilentladungserkennungseinrichtung (10) umfasst, die zur Teilentladungserkennung im zweiten Schaltfeld (9₂) eingerichtet ist, und zu den Zuschaltbedingungen für den zugehörigen Trennschalter (2₂) gehört, dass ein von der Teilentladungserkennungseinrichtung (10) erfasster Teilentladungspegel (Tp) einen vorgegebenen Maximalteilentladungspegel (Tpm) nicht überschreitet.

7. Vorrichtung nach einem der Ansprüche 4 bis 6, wobei sie eine Erdschlusserkennungseinrichtung (11) umfasst, die zur Erkennung eines intermittierenden Erdschlusses im zweiten Schaltfeld (9₂) eingerichtet ist, und zu den Zuschaltbedingungen (Zb) für den zugehörigen Trennschalter (2₂) gehört, dass die Erdschlusserkennungseinrichtung (11) keinen intermittierenden Erdschluss erkannt hat.

8. Vorrichtung nach einem der Ansprüche 1 bis 7, wobei sie eine extern ansteuerbare Deaktivierungseinheit (12) zur Deaktivierung der Trennschaltersteuerungsfunktion der Schaltersteuerungseinheit (6) aufweist.

9. Verfahren zur spannungsabgleichenden Trennschaltersteuerung in einem Stromnetz (1), insbesondere in einem Mittelspannungs-Verteilnetz, wobei das Stromnetz (1) einen Trennschalter (2) mit einer ersten Anschlussseite (2a), die von einer ersten Spannung (U₁) beaufschlagbar ist, und einer zweiten Anschlussseite (2b) aufweist, die von einer zweiten Spannung (U₂) beaufschlagbar ist, wobei das Verfahren umfasst:
- zeitwiederholtes Gewinnen einer ersten Messspannung (U_{1M}) durch eine Messung der ersten Spannung (U₁) mit einer vorgegebenen ersten Messgenauigkeit (Mg1),
- zeitwiederholtes Gewinnen einer zweiten Messspannung (U_{2M}) durch eine Messung der zweiten Spannung (U₂) mit einer vorgegebenen zweiten Messgenauigkeit (Mg2), die niedriger als die erste Messgenauigkeit (Mg1) ist,
- ein Gewinnen einer kalibrierten zweiten Messspannung (U₂ₖ) durch ein Kalibrieren der zweiten Messspannung (U_{2M}) mit der ersten Messspannung (U_{1M}) und
- Steuern des Trennschalters (2), wobei ein Schließen des Trennschalters (2) von einem Erfüllen einer oder mehrerer vorgegebener Zuschaltbedingungen (Zb) abhängig gemacht wird, zu denen gehört, dass eine Amplitudendifferenz (AU_{D}) der zuletzt gewonnenen kalibrierten zweiten Messspannung (U₂ₖ) und der zuletzt gewonnenen ersten Messspannung (U_{1M}) eine vorgegebene Maximalamplitudendifferenz (AUₘₐₓ) nicht überschreitet.

10. Verfahren nach Anspruch 9, wobei es durch eine Vorrichtung nach einem der Ansprüche 1 bis 8 durchgeführt wird.
